(19)

Europäisches
Patentamt
European
Patent Office
Office européen
des brevets

(11)  **EP 1 858 295 B1**

(12)  **EUROPEAN PATENT SPECIFICATION**

(45) Date of publication and mention
of the grant of the patent:
**26.06.2013  Bulletin 2013/26**

(51) Int Cl.:
*H04R 3/04* (2006.01)   *H04R 29/00* (2006.01)
*H03G 3/32* (2006.01)   *H03G 5/16* (2006.01)

(21) Application number: **06010399.1**

(22) Date of filing: **19.05.2006**

(54) **Equalization in acoustic signal processing**

Entzerrung zur Anwendung von akustischen Signalen

Égaliseur pour le traitement de signaux acoustiques

(84) Designated Contracting States:
**AT BE BG CH CY CZ DE DK EE ES FI FR GB GR
HU IE IS IT LI LT LU LV MC NL PL PT RO SE SI
SK TR**

(43) Date of publication of application:
**21.11.2007  Bulletin 2007/47**

(73) Proprietor: **Nuance Communications, Inc.
Burlington, MA 01803-4613 (US)**

(72) Inventors:
 • **Schmidt, Gerhard Uwe**
  **89081 Ulm (DE)**
 • **Haulick, Tim**
  **89143 Blaubeuren (DE)**
 • **Buck, Markus**
  **88400 Biberach (DE)**

(74) Representative: **Grünecker, Kinkeldey,
Stockmair & Schwanhäusser
Leopoldstrasse 4
80802 München (DE)**

(56) References cited:
 **US-A- 5 768 398      US-A1- 2003 108 209
 US-B1- 7 006 624**

 • **BREINING C ET AL: "Acoustic echo control, an
  application of very-high-order adaptive filters"
  IEEE SIGNAL PROCESSING MAGAZINE, vol. 16,
  no. 4, 1 July 1999 (1999-07-01), pages 42-68,
  XP011089842 PISCATAWAY, NJ, US ISSN:
  1053-5888**
 • **GLENTIS G O ET AL: "Efficient Least Squares
  Adaptive Algorithms for FIR Transversal
  Filtering" 1 June 1999 (1999-06-01), IEEE SIGNAL
  PROCESSING MAGAZINE, IEEE SERVICE
  CENTER, PISCATAWAY, NJ, US, PAGE(S) 13-41 ,
  XP002268696 ISSN: 1053-5888 * the whole
  document ***

**EP 1 858 295 B1**

## Description

### Field of Invention

The present invention relates to a system and a method for acoustic signal processing and, in particular, to enhancing the quality of speech signals in a communication system received from a remote party by equalizing the signals to be output by loudspeakers.

### Background of the invention

The enhancement of the quality of signals received in a communication system is a central topic in acoustic and, in particular, speech signal processing. The communication between two parties is often carried out in a noisy background environment and noise reduction as well as echo compensation are necessary to guarantee intelligibility. A prominent example is hands-free voice communication in vehicles. Hands-free telephones provide comfortable and safe communication systems of particular use in vehicles.

US - B1 - 7 006 624 discloses a loudspeaker volume control arrangement for a telephone having a loudspeaker and a microphone which controls the loudspeaker volume of the telephone based on the estimated distance between the microphone and the loudspeaker.

US - A - 5 768 398 discloses a signal amplification system with an automatic equalizer, wherein the equalizer transfer function is set independent on the estimated transfer function from a playback element to a pick up element. An echo canceller is provided for determining the transfer function and the transfer of the equalizer can be determined from this transfer function

US 2003/108209 A1 discloses a communication device that includes an earpiece), a sensor, and an active equalization circuit. The active equalization circuit is coupled to the sensor and equalizes the acoustic output signal using the response signal.

C. Breining et al., in a paper entitled, "Acoustic echo control, an application of very-high-order adaptive filters", IEEE Signal Processing Magazine, vol. 16, no. 4, 1 July 1999, pages 42-68, describe an acoustic echo cancellation means comprising verhy-high-order adaptive filters.

G.-O. Glentis et al., in a paper entitled, "Efficient Least Squares Adaptive Algorithms for FIR Transversal Filtering", IEEE Signal Processing Magazine, 1 June 1999, pages 13-41, fives an overview over algorithms for adaptive transversal FIR filtering.

Of particular importance is the handling of signals of the remote subscriber, which are emitted by the loudspeakers and therefore received again by the microphone(s), since otherwise unpleasant echoes can severely affect the quality and intelligibility of voice conversation. In the worst case acoustic feedback can even lead to a complete breakdown of communication.

One main problem lies in the reverberating characteristics of the room. In the case of hand-free telephones in motor vehicles the detection of the interior acoustics becomes very difficult, since abrupt changes in the acoustics, for example, owing to movements of the vehicle occupants have to be compensated.

To overcome the above mentioned problems means for acoustic echo compensation are provided, which basically works as follows. A replica of the acoustic feedback is synthesized and a compensation signal is obtained from the received signal of the loudspeakers. This compensation signal is subtracted from the sending signal of the microphone thereby generating a resulting signal to be sent to the remote subscriber.

Despite the recent developments and improvements in noise reduction and echo compensation, the intelligibility in hands-free telephony of the art, e.g., still suffers from distortions and the quality of acoustic signals output by loudspeakers are still noticeably distorted and deteriorated by noise and echo components.

It is therefore the problem underlying the present invention to overcome the above-mentioned drawbacks and to provide a system and a method for acoustic and speech signal processing, in particular, suitable for hands-free telecommunication systems, exhibiting improved acoustic properties as efficient acoustic echo compensation and an improved equalization of the acoustic output signals.

### Description of the invention

The problem is solved by a system according to claim 1 claiming a system for signal processing of an acoustic input signal, in particular, a speech input signal, the system comprising at least one loudspeaker; at least one microphone; an echo compensation filtering means configured to receive at least one microphone signal from the at least one microphone said at least one microphone signal being different from the acoustic input signal and being generated on the basis of a loudspeaker signal output by the at least one loudspeaker and comprising echo compensation filter coefficients determined on the basis of the at least one microphone signal; and an equalization filtering means configured to a) receive the acoustic input signal; b) equalize the acoustic input signal; and c) output the equalized acoustic input signal to the at least one loudspeaker ; and wherein the equalization filter coefficients $h_{C,i}(m)$ are determined on the basis of the echo compensation filter coefficients; and a reference filtering means comprising reference filter coefficients representing a predetermined reference frequency response and in that the echo compensation filter coefficients are determined on the basis of the reference filter coefficients; and wherein the equalization filtering means is configured to equalize the acoustic input signal by solving the linear algebraic equation system

$$
\begin{bmatrix}
r_0(n) & r_1(n) & \cdots & r_{N_C-1}(n) \\
r_1(n) & r_0(n) & \cdots & r_{N_C-2}(n) \\
\vdots & \vdots & \ddots & \vdots \\
r_{N_C-1}(n) & r_{N_C-2}(n) & \cdots & r_0(n)
\end{bmatrix}
\begin{bmatrix}
h_{C,0}(n) \\
h_{C,1}(n) \\
\vdots \\
h_{C,N_C-1}(n)
\end{bmatrix}
=
\begin{bmatrix}
r_1(n) \\
r_2(n) \\
\vdots \\
r_{N_C}(n)
\end{bmatrix}
$$

wherein the coefficients $r_i(n)$ are given by

$$
r_i(n) = \frac{1}{N-1} \sum_{k=0}^{N-i-1} \hat{h}_{LR,k}(n)\hat{h}_{LR,k+i}(n)
$$

where n is a discrete time index and $\hat{h}_{LR,k}(n)$ are filter coefficients of the echo compensation filtering means and N is the number of filter coefficients of the echo compensation filtering means and $N_C$ is the number of filter coefficients of the equalization filtering means used for equalizing the first acoustic input signal, respectively.

The equalization filtering means processes the acoustic input signal by boosting or attenuating the signals over a pre-determined frequency range. The equalization filtering means may comprise a shelving filter for selectively boosting/ attenuating either the low or high frequency range and a peaking filter for boosting/attenuating signals with the center frequency, bandwidth in-band and out-band gains being separately adjustable. The equalization filtering means may comprise a parametric equalizer that combines one or more shelving filters and peaking filters.

According to the present invention, a microphone signal is echo compensated by the echo compensation filtering means. For this, the filter coefficients of the echo compensation filtering means are to be determined appropriately. By determining the filter coefficients of the equalization filtering means on the basis of the filter coefficients of the echo compensation filtering means, the quality of the equalized acoustic signals, in particular, speech signals is significantly enhanced.

The number of the filter coefficients of the equalization filtering means can be chosen smaller than the number of the echo compensation filtering means in order to accelerate the total filtering process.

Consider a communication of a near party using the inventive system and a remote party. Acoustic input signals received from the remote party are processed by equalizing and the equalized signals are output by loudspeakers. The signals output by the loudspeakers are detected by a microphone that generates microphone signals.

These microphone signals are echo compensated by the echo compensation filtering means. The very first acoustic input signal(s) received from the remote party at the beginning of the conversation may be used to initialize the echo compensation filtering means and thereby the equalization filtering means. In particular, these very first acoustic input signal(s) may not be equalized.

After initialization the above described system can be used for communication between the remote and the near parties that is characterized by an improved intelligibility due to the echo compensation in combination with the equalization wherein the latter is performed by determining equalization filter coefficients of the equalization filtering means based on the echo compensation filter coefficients of the echo compensation filtering means.

The echo compensation filtering means is preferably an adaptive filtering means, i.e. the filter coefficients are not time-independent but rather can be dynamically adjusted. Adjustment may be performed every sampling time, preferably less often, e.g., a few times per second. By employment of and adaptive echo compensation filtering means the system can react on dynamic changes in a transfer function describing the overall transfer from the input signal via the loudspeaker(s) and the room, e.g., a passenger compartment, to the microphone(s). At least one microphone is preferably placed close to a listener. If the inventive system is installed in a passenger compartment a microphone can be installed, e.g., close to or in a head rest.

When used in passenger compartment in which microphones and loudspeakers are installed for communication with a remote party, dynamic changes caused by the movement of passengers, e.g., can be taken into account by accordingly automatically adjusting the filter coefficients of the adaptive echo compensation filtering means. It should be noted that front passengers in a cabin might represent the remote party and back passengers the near party or vice versa.

The adaptive echo compensation filtering means is preferably an FIR filtering means configured to be adaptable by an NLMS algorithm for fast convergence of the calculation procedure of the echo compensation filter coefficients. In order to further increase the convergence speed of the calculation, the system disclosed herein may also comprise a predictive pre-filtering means, in particular, a linear prediction coding (LPC) filter to determine an FIR filter that can optimally predict future samples of the underlying autoregressive process based on a linear combination of past samples. In this context, it should be noted that any signal time delay / signal traveling time introduced by the filtering means should be kept as small as possible.

Downstream of the microphone(s) a microphone amplifier(s) may be connected and a loudspeaker amplifier(s) may be provided upstream of the loudspeaker(s) that may allow for a variable gain. The amplifiers may be simply necessary components within the A/D- and D/A-processing and/or may be controllable by a user to be useful for further increasing the intelligibility of the communication.

The system for signal processing may further comprise a pre-filtering means that comprises filter coefficients that are determined to model the transfer function of the at least one microphone and that is configured to receive the equalized acoustic input signal and to output a signal based on the equalized acoustic input signal and the transfer function of the at least one microphone to the echo compensation filtering means. The provision of such a pre-filtering means allows for preventing that the frequency response of the at least one microphone is undesirably corrected.

If the system comprises at least one microphone that is a directional microphone, the filter coefficients of the pre-filtering means may be determined to model the transfer function of the directional microphone only in direction of a loudspeaker that is located closer to the directional microphone than all the other loudspeakers. Other transfer functions are of minor importance and can be neglected for economic reasons in this case.

The used microphone may be part of a microphone array comprising at least one directional microphone and the microphone signals to be echo compensated might be beamformed by a beamforming means used to improve the signal quality in the context of a multi-channel approach.

The system can be configured to determine the equalization filter coefficients on the basis of the echo compensation filter coefficients by solving a linear equation system using a recursive algorithm, in particular, the Levinson-Durbin algorithm. The Levinson-Durbin algorithm is a robust and relatively fast procedure, as compared, e.g., to standard Gauss elimination, for recursively solving linear equation systems. The mentioned linear equation system includes the equalization filter coefficients that are to be determined and the echo compensation filter coefficients.

According to another example of the system for signal processing, additional noise reduction filtering means, either adaptive or non-adaptive ones, may be employed to further increase the quality of the processed acoustic input signal. The acoustic input signal received from the remote part may be processed for noise reduction by the noise reduction filtering means before equalization.

The present invention also provides a hands-free set comprising one of the examples for the system for signal processing described above and, in particular, a hands-free system configured to be installed in a vehicle as an automobile. The invention further provides a vehicles comprising the above-mentioned that is installed therein.

The above mentioned problem is also solved by a method for enhancing the quality of a first acoustic input signal, comprising the steps of generating a loudspeaker signal from a second acoustic input signal by at least one loudspeaker; generating at least one microphone signal by at least one microphone on the basis of the loudspeaker signal wherein the at least one microphone signal is different from the acoustic input signal; adapting filter coefficients of an echo compensation filtering means in order to echo compensate the at least one microphone signal; and receiving and equalizing the first acoustic input signal by an equalization filtering means comprising filter coefficients $h_{C,i}(m)$ determined on the basis of the filter coefficients of the echo compensation filtering means; and providing a pre-determined reference frequency response and determining the echo compensation filter coefficients on the basis of the pre-determined reference frequency; and

wherein the equalization is performed by solving the linear algebraic equation system

$$\begin{bmatrix} r_0(n) & r_1(n) & \cdots & r_{N_C-1}(n) \\ r_1(n) & r_0(n) & \cdots & r_{N_C-2}(n) \\ \vdots & \vdots & \ddots & \vdots \\ r_{N_C-1}(n) & r_{N_C-2}(n) & \cdots & r_0(n) \end{bmatrix} \begin{bmatrix} h_{C.0}(n) \\ h_{C.1}(n) \\ \vdots \\ h_{C.N_C-1}(n) \end{bmatrix} = \begin{bmatrix} r_1(n) \\ r_2(n) \\ \vdots \\ r_{N_C}(n) \end{bmatrix}$$

wherein the coefficients $r_i(n)$ are given by

$$r_i(n) = \frac{1}{N-1} \sum_{k=0}^{N-i-1} \hat{h}_{LR,k}(n) \hat{h}_{LR,k+i}(n)$$

where n is a discrete time index and $h_{LB}(n)$ are filter coefficients of the echo compensation filtering means and N is the number of filter coefficients of the echo compensation filtering means and $N_C$ is the number of filter coefficients of an equalization filtering means used for equalizing the first acoustic input signal, respectively.

The microphone detects loudspeaker signals. The second acoustic input signal usually is a signal received from a remote party by a near party before, e.g., immediately before, the first acoustic input signal. The second acoustic input signal is received by the loudspeaker that generates a loudspeaker signal on the basis of the received second acoustic input signal. The echo compensating process for reducing the echo effects is carried out by an adaptive echo compensation filtering means, preferably, an adaptive FIR (finite impulse response) filter. The FIR filtering means may be dynamically, e.g., a few times per second, adapted by an NLMS (normalized least mean square) method. Both the microphone and the loudspeaker signals may be amplified. In addition, the echo compensation may be accompanied by predictive pre-filtering for increasing the convergence speed of the calculation procedure for the filter coefficients of the echo compensation filtering means.

The equalization of the first acoustic input signal is carried out on the basis of the filter coefficients of the echo compensation filtering means. Thereby, the quality of the first acoustic input signal is significantly enhanced. The equalized first acoustic input signal can be output by a loudspeaker. The intelligibility of the signal output by the loudspeaker is improved as compared with a loudspeaker output of the first acoustic input signal without equalization and as compared to communication system of the art.

Adapting of the filter coefficients of the echo compensation filtering means may be performed on the basis of a beamformed microphone signal, if directional microphones are employed. The echo compensation of the microphone signal may comprise LPC filtering.

According to one example of the inventive method the second acoustic input signal is pre-filtered by means of a pre-filtering means that models the transfer function of the at least one microphone to generate a pre-filtered signal and the echo compensation filtering means is adapted on the basis of the pre-filtered signal. Thereby, undesired correction of the frequency response of the microphone is prevented.

If at least one of microphones used to generate the at least one microphone signal is a directional microphone, the at least one microphone signal is generated by at least one directional microphone and the pre-filtering means according to an embodiment of the inventive method models the transfer function of the directional microphone in direction of a loudspeaker that is located closer to the directional microphone than all the other loudspeakers.

The length of the equalization filtering means $N_C$ (e.g. 10) is preferably shorter than the length of the echo compensation filtering means N (e.g. 256). The solution of the above equation system may be calculated by means of a recursive method as, e.g., the Levinson-Durbin algorithm.

Further filtering of the (equalized) first and/or second acoustic input signal to reduce noise may be preferred. The disclosed method can advantageously be incorporated in a hands-free set, in particular, in a hands-free set installed in a vehicle.

The invention also provides a computer program product, comprising one or more computer readable media having computer-executable instructions for performing the steps of one of the examples for the inventive method described above.

Additional features and advantages of the present invention will be described with reference to the drawings. In the description, reference is made to the accompanying figures that are meant to illustrate preferred embodiments of the invention. It is understood that such embodiments do not represent the full scope of the invention.

Figure 1 illustrates basic components of an example for the inventive system including an equalization filtering means that is adjusted by means of an echo compensation filtering means.

Figure 2 shows an example for the inventive system including an equalization filtering means that is adjusted by means of an adaptive echo compensation filtering means as well as a reference filtering means for a desired reference response and a pre-filtering means modeling the microphone transfer function.

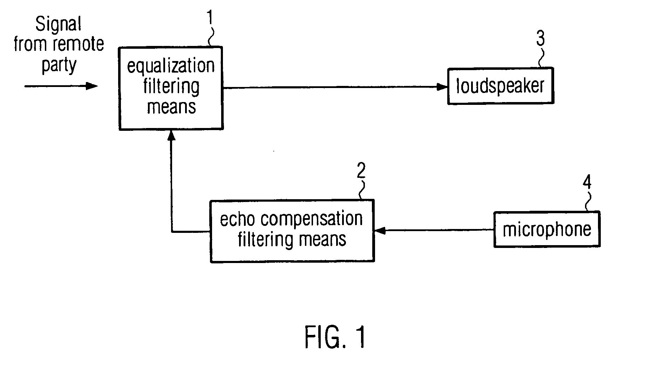

Basic components of an example of the system for signal processing disclosed herein are illustrated in Fig. 1. An acoustic input signal is filtered by an equalization filtering means 1 comprising equalization filter coefficients

$$\mathbf{h}_C(n) = \left[h_{C,0}(n), h_{C,1}(n), ..., h_{C,N_C-1}(n)\right]^\mathsf{T}$$

that are determined for enhancement of the quality of the signal received from a remote party. The upper index T denotes the transposition operation. The equalization filter coefficients are calculated from echo compensation filter coefficients

$$\hat{\mathbf{h}}_{LR}(n) = \left[\hat{h}_{LR,0}(n), \hat{h}_{LR,1}(n), ..., \hat{h}_{LR,N-1}(n)\right]^\mathsf{T}$$

of an echo compensation filtering means 2. Preferably, narrow band drops or raises are ignored by the equalization filtering process. According to this example, it is the spectral envelope of a speech signal received from the remote party that is modified only by the equalization filtering means 1.

An output signal of the equalization filtering means 1 is received by a loudspeaker 3. The equalized signal output by the loudspeaker 3 can be detected by a microphone 4.

The loudspeaker 3 and the microphone 4 are parts of a communication system of a near communication party. The microphone 4 used for communication of a near party with a remote communication party detects the signals that are received from the remote party, equalized by the equalization filtering means 1 and output by the loudspeaker 3. The microphone signals generated by the microphone 4 from the detected loudspeaker signals, however, are filtered by the echo compensation filtering means 2. The equalization filter coefficients are calculated from the echo compensation filter coefficients as follows.

First, the $N_c$+1 coefficients

$$r_i(n) = \frac{1}{N-1} \sum_{k=0}^{N-i-1} \hat{h}_{LR,k}(n)\hat{h}_{LR,k+i}(n)$$

of the vector

$$\mathbf{r}(n) = \left[r_0(n), r_1(n), ..., r_{N_c}(n)\right]^\mathsf{T}$$

are calculated. This calculation is not necessarily performed for any sampling time, but preferably, a few times each second only. Moreover, the length of the equalization filtering means, i.e. the number of equalization filter coefficients, might be less than 20, preferably, between 10 and 20. The length of the echo compensation filtering means 2 may be chosen as, e.g., N = 256. The equalization filter coefficients are calculated by solving the linear equation system:

$$\begin{bmatrix} r_0(n) & r_1(n) & \cdots & r_{N_c-1}(n) \\ r_1(n) & r_0(n) & \cdots & r_{N_c-2}(n) \\ \vdots & \vdots & \ddots & \vdots \\ r_{N_c-1}(n) & r_{N_c-2}(n) & \cdots & r_0(n) \end{bmatrix} \begin{bmatrix} h_{c,0}(n) \\ h_{c,1}(n) \\ \vdots \\ h_{c,N_c-1}(n) \end{bmatrix} = \begin{bmatrix} r_1(n) \\ r_2(n) \\ \vdots \\ r_{N_c}(n) \end{bmatrix}$$

According to this example, the solution is calculated by means of the recursive Levinson-Durbin method. The thus calculated solution is phase minimal, i.e. signal travel time introduced by the filtering means is minimized. Any other recursive solution method known in the art might be used instead.

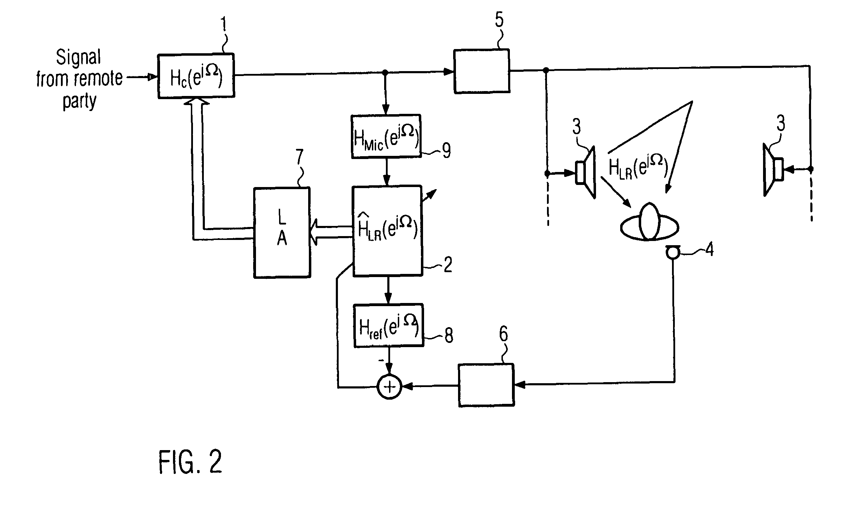

Fig. 2 shows another example of the inventive system for signal processing. In this example, the system is installed in a passenger compartment of a vehicle. The system comprises an equalization filtering means 1 and an echo compensation filtering means 2. The equalization filtering means 1 is configured to equalize a signal received from a remote party. The echo compensation filtering means 2 is an adaptive FIR filter (finite impulse response filter). It would, however, also be possible to employ an IIR filter (infinite impulse response filter) for the echo compensation filtering means 2. In this example, the filter coefficients of the echo compensation filtering means 2 are adapted by means of an NLMS algorithm. Any other appropriate adaptive method can be used instead.

Preferably, the echo compensation filtering means 2 includes a predictive pre-filtering means. The equalized signal is output by loudspeakers 3 installed in the passenger compartment. The loudspeaker-room-listener transfer function is represented by $H_{LR}e^{(j\Omega)}$. The near communication party uses a microphone 4, preferably, installed close to the speaker/listener. A loudspeaker amplifier 5 is connected upstream of the loudspeakers 3 and a microphone amplifier 6 is connected downstream of the microphone 4.

The equalization filter coefficients of the FIR equalization filtering means 1 are calculated by means of the echo compensation filter coefficients of the echo compensation filtering means 2. The calculation is performed by a linear algebra unit 7, solving the linear equation system above for the $h_{c,0}(n), h_{c,1}(n), ..., h_{c,Nc-1}(n)$.

The system for signal processing also comprises a reference filtering means 8 to provide a desired reference frequency response $H_{ref}(e^{j\Omega})$ of the total transfer from the input signal to a signal detected close to the ears of a listener, i.e. close to the microphone 4. The equalization filter coefficients are determined in order to approximate the reference frequency response by

$$H_c(e^{j\Omega})H_{LR}(e^{j\Omega}) \approx H_{ref}(e^{j\Omega})$$

where $H_c(e^{j\Omega})$ denotes the frequency response of the equalization filtering means 1. If the microphone 4 or all microphones used, in general, are located at some relatively large distance from the listener's/speaker's ear, the difference between the transfer in the case of a microphone near the ear and the case in which a microphone is located spaced apart can be determined and, if need be, the reference transfer function can be appropriately be adapted for large differences.

According to the present example, the output of the equalization filtering means 1 is fed into a fixed pre-filtering means 9 used to model the transfer function $H_{Mic}(e^{j\Omega})$ of the microphone 4. If in the present example the microphone 4 is a directional microphone, the transfer function of this microphone to the loudspeaker 3 closest to this directional microphone should be used. The pre-filtering means 9 is connected upstream of the echo compensation filtering means 2 in order to avoid correction of the frequency response of the microphone 4.

At the beginning of a telephone call carried out with the above described system, the FIR equalization filtering means 1 is initialized by

$$\mathbf{h}_c(n) = [1, 0, ..., 0]^{\mathsf{T}}.$$

Amplification and/or damping caused by the equalization filtering means 1 might be modified by an appropriate modification of the first coefficient of the vector $\mathbf{r}(n)$.

**Claims**

1. System for signal processing of an acoustic input signal, comprising
   at least one loudspeaker (3);
   at least one microphone (4);
   an echo compensation filtering means (2) configured to receive at least one microphone signal from the at least one microphone (4) said at least one microphone signal being different from the acoustic input signal and being generated on the basis of a loudspeaker signal output by the at least one loudspeaker (3) and comprising echo compensation filter coefficients determined on the basis of the at least one microphone signal; and
   an equalization filtering means (1) configured to

   a) receive the acoustic input signal;
   b) equalize the acoustic input signal; and
   c) output the equalized acoustic input signal to the at least one loudspeaker (3);

   and wherein the equalization filter coefficients $h_{C,i}(m)$ are determined on the basis of the echo compensation filter coefficients; and
   a reference filtering means (8) comprising reference filter coefficients representing a predetermined reference frequency response and in that the echo compensation filter coefficients are determined on the basis of the reference filter coefficients; and
   wherein the equalization filtering means (1) is configured to equalize the acoustic input signal by solving the linear algebraic equation system

$$
\begin{bmatrix}
r_0(n) & r_1(n) & \cdots & r_{N_C-1}(n) \\
r_1(n) & r_0(n) & \cdots & r_{N_C-2}(n) \\
\vdots & \vdots & \ddots & \vdots \\
r_{N_C-1}(n) & r_{N_C-2}(n) & \cdots & r_0(n)
\end{bmatrix}
\begin{bmatrix}
h_{C,0}(n) \\
h_{C,1}(n) \\
\vdots \\
h_{C,N_C-1}(n)
\end{bmatrix}
=
\begin{bmatrix}
r_1(n) \\
r_2(n) \\
\vdots \\
r_{N_C}(n)
\end{bmatrix}
$$

   wherein the coefficients $r_i(n)$ are given by

$$
r_i(n) = \frac{1}{N-1} \sum_{k=0}^{N-i-1} \hat{h}_{LR,k}(n) \hat{h}_{LR,k+i}(n)
$$

   where n is a discrete time index and $\hat{h}_{LR,k}(n)$ are filter coefficients of the echo compensation filtering means (2) and N is the number of filter coefficients of the echo compensation filtering means and $N_C$ is the number of filter coefficients of the equalization filtering means (1) used for equalizing the first acoustic input signal, respectively.

2. The system according to claim 1 wherein the echo compensation filtering means (2) is an adaptive filtering means.

3. The system according to claim 2, wherein the adaptive echo compensation filtering means (2) is an FIR filtering means, in particular, configured to be adaptable by an normalized least means square algorithm.

4. The system according to claim 2 or 3, wherein the echo compensation filtering means (2) comprises a predictive pre-filtering means.

5. The system according to one of the claims 2 - 4, further comprising a loudspeaker amplifier (5) for each loudspeaker and/or a microphone amplifier (6) for each microphone, in particular, configured to be controlled by a user.

6. The system according to one of the preceding claims, further comprising a pre-filtering means (9) that comprises filter coefficients, which are determined for modeling the transfer function of the at least one microphone (4); and
that is configured to receive the equalized acoustic input signal; and
to output a signal based on the equalized acoustic input signal and the transfer function of the at least one microphone (4) to the echo compensation filtering means (2).

**7.** The system according to claim 6, comprising a microphone array comprising at least one directional microphone and further comprising a beamforming means.

**8.** The system according to one of the claims 6 or 7, wherein at least one microphone (4) is a directional microphone, and wherein the filter coefficients of the pre-filtering means (9) are determined for modeling the transfer function of the directional microphone in direction of one or more loudspeakers that are located closer to the at least one directional microphone than all the other loudspeakers.

**9.** The system according to one of the preceding claims, wherein the system is configured to determine the equalization filter coefficients on the basis of the echo compensation filter coefficients by solving a linear equation system, particular, using a recursive algorithm.

**10.** The system according to one of the preceding claims, further comprising an adaptive or non-adaptive noise reduction filtering means configured to reduce noise of the acoustic input signal and/or of the equalized acoustic input signal.

**11.** Hands-free set comprising the system according to one of the claims 1 - 10.

**12.** Hands-free set according to claim 11, configured to be installed in a passenger compartment of an automobile.

**13.** Method for enhancing the quality of a first acoustic input signal, comprising the steps of:

generating a loudspeaker signal from a second acoustic input signal by at least one loudspeaker (3);
generating at least one microphone signal by at least one microphone (4) on the basis of the loudspeaker signal wherein the at least one microphone signal is different from the acoustic input signal;
adapting filter coefficients of an echo compensation filtering means (2) in order to echo compensate the at least one microphone signal; and
receiving and equalizing the first acoustic input signal by an equalization filtering means comprising filter coefficients $h_{C,i}(m)$ determined on the basis of the filter coefficients of the echo compensation filtering means (2); and
providing a pre-determined reference frequency response and determining the echo compensation filter coefficients on the basis of the pre-determined reference frequency; and
wherein the equalization is performed by solving the linear algebraic equation system

$$
\begin{bmatrix}
r_0(n) & r_1(n) & \cdots & r_{N_C-1}(n) \\
r_1(n) & r_0(n) & \cdots & r_{N_C-2}(n) \\
\vdots & \vdots & \ddots & \vdots \\
r_{N_C-1}(n) & r_{N_C-2}(n) & \cdots & r_0(n)
\end{bmatrix}
\begin{bmatrix}
h_{C,0}(n) \\
h_{C,1}(n) \\
\vdots \\
h_{C,N_C-1}(n)
\end{bmatrix}
=
\begin{bmatrix}
r_1(n) \\
r_2(n) \\
\vdots \\
r_{N_C}(n)
\end{bmatrix}
$$

wherein the coefficients $r_i(n)$ are given by

$$
r_i(n) = \frac{1}{N-1} \sum_{k=0}^{N-i-1} \hat{h}_{LR,k}(n) \hat{h}_{LR,k+i}(n)
$$

where n is a discrete time index and $\hat{h}_{LR,k}(n)$ are are filter coefficients of the echo compensation filtering means (2) and N is the number of filter coefficients of the echo compensation filtering means and $N_C$ is the number of filter coefficients of an equalization filtering means (1) used for equalizing the first acoustic input signal, respectively.

14. The method according to claim 13, further comprising

pre-filtering the second acoustic input signal by means of a pre-filtering means (9) that models the transfer function of the at least one microphone (4) to generate a pre-filtered signal;

and wherein the filter coefficients of the echo compensation filtering means (2) are adapted on the basis of the pre-filtered signal.

15. The method according to claim 14, wherein the at least one microphone signal is generated by at least one directional microphone and the pre-filtering models the transfer function of the directional microphone in direction of one or more loudspeakers that are located closer to the directional microphone than all the other loudspeakers.

16. The method according to one of the claims 13 - 15, further comprising noise reduction filtering of the first acoustic input signal and/or the equalized first acoustic input signal and/or the second acoustic input signal.

17. Computer program product, comprising one or more computer readable media having computer-executable instructions for performing the steps of the method according to one of the Claims 13 - 16.

**Patentansprüche**

1. System zur Signalverarbeitung eines akustischen Eingangssignals, das umfasst

zumindest einen Lautsprecher (3);

zumindest ein Mikrofon (4);

eine Echokompensationsfiltereinrichtung (2), die dazu ausgebildet ist, zumindest ein Mikrofonsignal von dem zumindest einen Mikrofon (4) zu erhalten, wobei das genannte zumindest eine Mikrofonsignal von dem akustischen Eingangssignal verschieden ist und auf der Grundlage eines Lautsprechersignals erzeugt wird, das von dem zumindest einen Lautsprecher (3) ausgegeben wird, und mit Echokompensationsfilterkoeffizienten, die auf der Grundlage des zumindest einen Mikrofonsignals bestimmt werden; und

eine Equalizer-Filtereinrichtung (1), die dazu ausgebildet ist,

a) das akustische Eingangssignal zu empfangen;

b) das akustische Eingangssignal gleichzurichten; und

c) das gleichgerichtete akustische Eingangssignal an den zumindest einen Lautsprecher (3) auszugeben;

und wobei die Equalizer-Filterkoeffizienten $h_{C,i}(n)$ auf der Grundlage der Echokompensationsfilterkoeffizienten bestimmt werden; und

eine Referenzfiltereinrichtung (8), die Referenzfilterkoeffizienten umfasst, die eine vorbestimmte Referenzfrequenzantwort darstellen, und wobei die Echokompensationsfilterkoeffizienten auf der Grundlage der Referenzfilterkoeffizienten bestimmt werden; und

wobei die Equalizer-Filtereinrichtung (1) dazu ausgebildet ist, das akustische Eingangssignal durch Lösen des linearen Gleichungssystems

$$\begin{bmatrix} r_0(n) & r_1(n) & \cdots & r_{N_C-1}(n) \\ r_1(n) & r_0(n) & \cdots & r_{N_C-2}(n) \\ \vdots & \vdots & \ddots & \vdots \\ r_{N_C-1}(n) & r_{N_C-2}(n) & \cdots & r_0(n) \end{bmatrix} \begin{bmatrix} h_{C,0}(n) \\ h_{C,1}(n) \\ \vdots \\ h_{C,N_C-1}(n) \end{bmatrix} = \begin{bmatrix} r_1(n) \\ r_2(n) \\ \vdots \\ r_{N_C}(n) \end{bmatrix}$$

gleichzurichten, wobei die Koeffizienten $r_i(n)$ gegeben sind durch

$$r_i(n) = \frac{1}{N-1} \sum_{k=0}^{N-i-1} \hat{h}_{LR,k}(n)\hat{h}_{LR,k+i}(n)$$

wobei n ein diskreter Zeitindex ist und $\hat{h}_{LR,k}(n)$ Filterkoeffizienten der Echokompensationsfiltereinrichtung (2) sind und N die Anzahl der Filterkoeffizienten der Echokompensationsfiltereinrichtung ist und $N_C$ die Anzahl der Filterkoeffizienten einer Equalizer-Filtereinrichtung (1) ist, die für das Gleichrichten des ersten akustischen Eingangssignals verwendet wird.

2. Das System gemäß Anspruch 1, in dem die Echokompensationsfiltereinrichtung (2) eine adaptive Filtereinrichtung ist.

3. Das System gemäß Anspruch 2, in dem die adaptive Echokompensationsfiltereinrichtung (2) eine FIR-Filtereinrichtung ist, die insbesondere dazu ausgebildet ist, durch einen normierten Algorithmus kleinster mittlerer quadratischer Fehler adaptierbar zu sein.

4. Das System gemäß Anspruch 2 oder 3, in dem die Echokompensationsfiltereinrichtung (2) eine prädikative Vorfiltereinrichtung umfasst.

5. Das System gemäß einem der Ansprüche 2 - 4, das weiterhin für jeden Lautsprecher einen Lautsprecherverstärker (5) und/oder für jedes Mikrofon einen Mikrofonverstärker (6) umfasst, der insbesondere von einem Nutzer gesteuert werden kann.

6. Das System gemäß einem der vorhergehenden Ansprüche, das weiterhin eine Vorfiltereinrichtung (9) umfasst die Filterkoeffizienten umfasst, die für das Modellieren der Übertragungsfunktion des zumindest einen Mikrofons (4) bestimmt werden; und
die dazu ausgebildet ist, das gleichgerichtete akustische Eingangssignal zu empfangen; und
ein Signal auf der Grundlage des gleichgerichteten akustischen Eingangssignals und der Übertragungsfunktion des zumindest einen Mikrofons (4) an die Echokompensationsfiltereinrichtung (2) auszugeben.

7. Das System gemäß Anspruch 6, das eine Mikrofonanordnung mit zumindest einem Richtmikrofon umfasst und weiterhin eine Beamforming-Einrichtung umfasst.

8. Das System gemäß einem der Ansprüche 6 oder 7, in dem zumindest ein Mikrofon (4) ein Richtmikrofon ist, und in dem die Filterkoeffizienten der Vorfiltereinrichtung (9) zum Modellieren der Übertragungsfunktion des Richtmikrofons in Richtung von einem oder mehreren Lautsprechern, die sich näher an dem zumindest einen Richtmikrofon befinden als alle anderen Lautsprecher, bestimmt werden.

9. Das System gemäß einem der vorhergehenden Ansprüche, in dem das System dazu ausgebildet ist, die Equalizer-Filterkoeffizienten auf der Grundlage der Echokompensationsfilterkoeffizienten durch Lösen eines linearen Gleichungssystems, insbesondere unter Verwenden eines rekursiven Algorithmus, zu bestimmen.

10. Das System gemäß einem der vorhergehenden Ansprüche, das weiterhin eine adaptive oder nicht-adaptive Geräuschreduzierungsfiltereinrichtung umfasst, die dazu ausgebildet ist, Geräusch des akustischen Eingangssignals und/oder des gleichgerichteten akustischen Eingangssignals zu verringern.

11. Freihandvorrichtung, die das System gemäß einem der Ansprüche 1 - 10 umfasst.

12. Freihandvorrichtung gemäß Anspruch 11, die so ausgebildet ist, dass sie in einem Fahrgastraum eines Kraftfahrzeugs installiert werden kann.

13. Verfahren zum Verbessern der Qualität eines ersten akustischen Eingangssignals, das die Schritte umfasst:

Erzeugen eines Lautsprechersignals aus einem zweiten akustischen Eingangssignal mithilfe von zumindest einem Lautsprecher (3);
Erzeugen von zumindest einem Mikrofonsignal durch zumindest ein Mikrofon (4) auf der Grundlage des Lautsprechersignals, wobei das zumindest eine Mikrofonsignal von dem akustischen Eingangssignal verschieden ist;
Adaptieren von Filterkoeffizienten einer Echokompensationsfiltereinrichtung (2), um ein Echo in dem zumindest einen Mikrofonsignal zu kompensieren; und
Empfangen und Gleichrichten des ersten akustischen Eingangssignals durch eine Equalizer-Filtereinrichtung mit Filterkoeffizienten $h_{C,i}(n)$, die auf der Grundlage der Filterkoeffizienten der Echokompensationsfiltereinrichtung (2) bestimmt werden; und
Bereitstellen eine vorbestimmten Referenzfrequenzantwort und Bestimmen der Echokompensationsfilterkoeffizienten auf der Grundlage der vorbestimmten Referenzfrequenz; und
wobei die Gleichrichtung durch Lösen der linearen algebraischen Gleichungssystems

$$
\begin{bmatrix}
r_0(n) & r_1(n) & \cdots & r_{N_C-1}(n) \\
r_1(n) & r_0(n) & \cdots & r_{N_C-2}(n) \\
\vdots & \vdots & \ddots & \vdots \\
r_{N_C-1}(n) & r_{N_C-2}(n) & \cdots & r_0(n)
\end{bmatrix}
\begin{bmatrix}
h_{C,0}(n) \\
h_{C,1}(n) \\
\vdots \\
h_{C,N_C-1}(n)
\end{bmatrix}
=
\begin{bmatrix}
r_1(n) \\
r_2(n) \\
\vdots \\
r_{N_C}(n)
\end{bmatrix}
$$

ausgeführt wird, wobei die Koeffizienten $r_i(n)$ durch

$$
r_i(n) = \frac{1}{N-1} \sum_{k=0}^{N-i-1} \hat{h}_{LR,k}(n)\hat{h}_{LR,k+i}(n)
$$

gegeben sind, wobei n ein diskreter Zeitindex ist und $\hat{h}_{LR,k}(n)$ Filterkoeffizienten der Echokompensationsfiltereinrichtung (2) sind und N die Anzahl der Filterkoeffizienten der Echokompensationsfiltereinrichtung ist und $N_C$ die Anzahl der Filterkoeffizienten einer Equalizer-Filtereinrichtung (1) ist, die für das Gleichrichten des ersten akustischen Eingangssignals verwendet wird.

14. Das Verfahren gemäß Anspruch 13, das weiterhin umfasst Vorfiltern des zweiten akustischen Eingangssignals mithilfe einer Vorfiltereinrichtung (9), die die Übertragungsfunktion des zumindest einen Mikrofons (4) modelliert, um ein vorgefiltertes Signal zu erzeugen;
und wobei die Filterkoeffizienten der Echokompensationsfiltereinrichtung (2) auf der Grundlage der vorgefilterten Signale adaptiert werden.

15. Das Verfahren gemäß Anspruch 14, in dem das zumindest eine Mikrofonsignal durch zumindest ein Richtmikrofon erzeugt wird und das Vorfiltern die Übertragungsfunktion des Richtmikrofons in Richtung auf einen oder mehrere Lautsprecher, die sich näher an dem zumindest einen Richtmikrofon befinden als alle anderen Lautsprecher, modelliert.

16. Das Verfahren gemäß einem der Ansprüche 13 - 15, das weiterhin ein Geräuschreduzierungsfiltern des ersten akustischen Eingangssignals und/oder Gleichrichten des ersten akustischen Eingangssignals und/oder zweiten akustischen Eingangssignals umfasst.

17. Computerprogrammprodukt, das ein oder mehrere computerlesbare Medien umfasst, die computerausführbare Anweisungen zum Ausführen der Schritte des Verfahrens gemäß einem der Ansprüche 13 - 16 besitzen.

**Revendications**

1. Système de traitement de signal d'un signal d'entrée acoustique, comprenant
au moins un haut-parleur (3) ;
au moins un microphone (4) ;
un moyen de filtrage à compensation d'écho (2) configuré pour recevoir au moins un signal de microphone provenant dudit au moins un microphone (4), ledit au moins un signal de microphone étant différent du signal d'entrée acoustique et étant généré sur base d'une sortie de signal de haut-parleur par ledit au moins un haut-parleur (3), et comprenant des coefficients de filtre de compensation d'écho déterminés sur base dudit au moins un signal de microphone ; et un moyen de filtrage d'égalisation (1) configuré pour

    a) recevoir le signal d'entrée acoustique ;
    b) égaliser le signal d'entrée acoustique ; et
    c) sortir le signal d'entrée acoustique égalisé vers ledit au moins un haut-parleur (3) ;

et dans lequel les coefficients du filtre d'égalisation $h_{C,i}(n)$ sont déterminés sur base des coefficients du filtre de compensation d'écho ; et

un moyen de filtrage de référence (8) comprenant des coefficients de filtre de référence représentant une réponse en fréquence de référence prédéterminée, et dans lequel les coefficients de filtre de compensation d'écho sont déterminés sur base des coefficients de filtre de référence ; et

dans lequel le moyen de filtrage d'égalisation (1) est configuré pour égaliser le signal d'entrée acoustique en résolvant le système d'équations algébriques linéaires

$$
\begin{bmatrix}
r_0(n) & r_1(n) & \cdots & r_{N_C-1}(n) \\
r_1(n) & r_0(n) & \cdots & r_{N_C-2}(n) \\
\vdots & \vdots & \ddots & \vdots \\
r_{N_C-1}(n) & r_{N_C-2}(n) & \cdots & r_0(n)
\end{bmatrix}
\begin{bmatrix}
h_{C,0}(n) \\
h_{C,1}(n) \\
\vdots \\
h_{C,N_C-1}(n)
\end{bmatrix}
=
\begin{bmatrix}
r_1(n) \\
r_2(n) \\
\vdots \\
r_{N_C}(n)
\end{bmatrix}
$$

dans lequel les coefficients $r_i(n)$ sont donnés par

$$
r_i(n) = \frac{1}{N-1} \sum_{k=0}^{N-i-1} \hat{h}_{LR,k}(n)\hat{h}_{LR,k+i}(n)
$$

où $n$ est un index temporel discret et $\hat{h}_{LR,k}(n)$ sont des coefficients de filtre du moyen de filtrage à compensation d'écho (2), N est le nombre de coefficients de filtre du moyen de filtrage à compensation d'écho, et $N_C$ est le nombre de coefficients de filtre du moyen de filtrage à compensation d'écho (1) utilisés respectivement pour égaliser le premier signal d'entrée acoustique.

2. Système selon la revendication 1, dans lequel le moyen de filtrage à compensation d'écho (2) est un moyen de filtrage adaptatif.

3. Système selon la revendication 2, dans lequel le moyen de filtrage à compensation d'écho adaptatif (2) est un moyen de filtrage à réponse impulsionnelle finie FIR, soit Finite Impulse Response, configuré en particulier pour être adaptable à l'aide d'un algorithme à moindres carrés moyens normalisé.

4. Système selon la revendication 2 ou 3, dans lequel le moyen de filtrage à compensation d'écho (2) comprend un moyen de préfiltrage prédictif.

5. Système selon l'une des revendications 2 à 4, comprenant en outre un amplificateur de haut-parleur (5) pour chaque haut-parleur et/ou un amplificateur de microphone (6) pour chaque microphone, configuré en particulier pour être commandé par un utilisateur.

6. Système selon l'une des revendications précédentes, comprenant en outre un moyen de préfiltrage (9)
qui comprend des coefficients de filtre qui sont déterminés pour la modélisation de la fonction de transfert dudit au moins un microphone (4) ; et
qui est configuré pour recevoir le signal d'entrée acoustique égalisé ; et
pour sortir un signal sur base du signal d'entrée acoustique égalisé et de la fonction de transfert dudit au moins un microphone (4) vers le moyen de filtrage à compensation d'écho (2).

7. Système selon la revendication 6, comprenant un réseau de microphones comportant au moins un microphone directionnel, et comprenant en outre un moyen de formation de faisceau.

**8.** Système selon l'une des revendications 6 ou 7, dans lequel au moins un microphone (4) est un microphone directionnel, et dans lequel les coefficients de filtre du moyen de préfiltrage (9) sont déterminés pour modéliser la fonction de transfert du microphone directionnel en direction d'un ou plusieurs haut-parleurs qui se trouvent plus près dudit au moins un microphone directionnel que tous les autres haut-parleurs.

**9.** Système selon l'une des revendications précédentes, dans lequel le système est configuré pour déterminer les coefficients de filtre d'égalisation sur base des coefficients de filtre de compensation d'écho en résolvant un système d'équations linéaires, en utilisant en particulier un algorithme récursif.

**10.** Système selon l'une des revendications précédentes, comprenant en outre un moyen de filtrage à réduction de bruit adaptif ou non adaptif configuré pour réduire le bruit du signal d'entrée acoustique et/ou du signal d'entrée acoustique égalisé.

**11.** Kit mains libres comprenant le système selon l'une des revendications 1 à 10.

**12.** Kit mains libres selon la revendication 11, configuré pour être installé dans l'habitacle d'une automobile.

**13.** Procédé d'amélioration de la qualité d'un premier signal d'entrée acoustique, comprenant les étapes correspondant à :

la génération d'un signal de haut-parleur à partir d'un deuxième signal d'entrée acoustique par au moins un haut-parleur (3) ;
la génération d'au moins un signal de microphone par au moins un microphone (4) sur base du signal de haut-parleur, dans lequel ledit au moins un signal de microphone est différent du signal d'entrée acoustique ;
l'adaptation de coefficients de filtre d'un moyen de filtrage à compensation d'écho (2) de manière à compenser l'écho dudit au moins un signal de microphone ; et
la réception et l'égalisation du premier signal d'entrée acoustique par un moyen de filtrage d'égalisation comprenant des coefficients de filtre $h_{C,i}(n)$ déterminés sur base des coefficients de filtre du moyen de filtrage à compensation d'écho (2) ; et
la fourniture d'une réponse en fréquence de référence prédéterminée et la détermination des coefficients de filtre de compensation d'écho sur base de la fréquence de référence prédéterminée ; et
dans lequel l'égalisation est mise en oeuvre en résolvant le système d'équations algébriques linéaires

$$\begin{bmatrix} r_0(n) & r_1(n) & \cdots & r_{N_C-1}(n) \\ r_1(n) & r_0(n) & \cdots & r_{N_C-2}(n) \\ \vdots & \vdots & \ddots & \vdots \\ r_{N_C-1}(n) & r_{N_C-2}(n) & \cdots & r_0(n) \end{bmatrix} \begin{bmatrix} h_{C,0}(n) \\ h_{C,1}(n) \\ \vdots \\ h_{C,N_C-1}(n) \end{bmatrix} = \begin{bmatrix} r_1(n) \\ r_2(n) \\ \vdots \\ r_{N_C}(n) \end{bmatrix}$$

dans lequel les coefficients $r_i(n)$ sont donnés par

$$r_i(n) = \frac{1}{N-1} \sum_{k=0}^{N-i-1} \hat{h}_{LR,k}(n)\hat{h}_{LR,k+i}(n)$$

où n est un index temporel discret et $\hat{h}_{LR,k}(n)$ sont des coefficients de filtre du moyen de filtrage à compensation d'écho (2), N est le nombre de coefficients de filtre du moyen de filtrage à compensation d'écho, et $N_C$ est le nombre de coefficients de filtre d'un moyen de filtrage d'égalisation (1) utilisé respectivement pour égaliser le premier signal d'entrée acoustique.

**14.** Procédé selon la revendication 13, comprenant en outre
le préfiltrage du deuxième signal d'entrée acoustique au moyen d'un moyen de préfiltrage (9) qui modélise la fonction de transfert dudit au moins un microphone (4) pour générer un signal préfiltré ;
et dans lequel les coefficients de filtre du moyen de filtrage à compensation d'écho (2) sont adaptés sur base du signal préfiltré.

15. Procédé selon la revendication 14, dans lequel ledit au moins un signal de microphone est généré par au moins un microphone directionnel, et le préfiltrage modélise la fonction de transfert du microphone directionnel en direction d'un ou plusieurs haut-parleurs qui se trouvent plus près du microphone directionnel que tous les autres haut-parleurs.

16. Procédé selon l'une des revendications 13 à 15, comprenant en outre un filtrage de réduction de bruit du premier signal d'entrée acoustique et/ou du premier signal d'entrée acoustique égalisé et/ou du deuxième signal d'entrée acoustique.

17. Produit logiciel comprenant un ou plusieurs supports lisibles par un ordinateur qui comportent des instructions exécutables par un ordinateur pour mettre en oeuvre les étapes du procédé de l'une des revendications 13 à 16.

FIG. 1

FIG. 2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 7006624 B1
- US 5768398 A

- US 2003108209 A1

### Non-patent literature cited in the description

- **C. BREINING et al.** Acoustic echo control, an application of very-high-order adaptive filters. *IEEE Signal Processing Magazine,* 01 July 1999, vol. 16 (4), 42-68

- **G.-O. GLENTIS et al.** Efficient Least Squares Adaptive Algorithms for FIR Transversal Filtering. *IEEE Signal Processing Magazine,* 01 June 1999, 13-41